# EUROPÄISCHE PATENTSCHRIFT

(11) **EP 4 162 342 B1**
(45) Veröffentlichungstag und Bekanntmachung des Hinweises auf die Patenterteilung: **09.10.2024**
(21) Anmeldenummer: 22707217.0
(22) Anmeldetag: 26.01.2022
(51) Int. Cl.: G06F 1/16, H04M 1/02, H05K 9/00

(54) **GEHÄUSETEIL AUS KOHLEFASERVERSTÄRKTEM KUNSTSTOFF FÜR EINE ELEKTRONISCHE VORRICHTUNG**
HOUSING PART COMPOSED OF CARBON-FIBRE-REINFORCED PLASTIC FOR AN ELECTRONIC DEVICE
PARTIE DE BOÎTIER EN MATIÈRE PLASTIQUE RENFORCÉE PAR DES FIBRES DE CARBONE POUR UN DISPOSITIF ÉLECTRONIQUE

(30) Priorität: 27.01.2021 DE 102021101818
(43) Veröffentlichungstag der Anmeldung: 12.04.2023
(73) Patentinhaber: Carbon Mobile GmbH, 10781 Berlin (DE)
(72) Erfinder: KHALIFEH, Firas, 10115 Berlin (DE)
(74) Vertreter: Castell, Klaus
(86) Internationale Anmeldenummer: PCT/IB2022/050663
(87) Internationale Veröffentlichungsnummer: WO 2022/162541

(56) Entgegenhaltungen:
- US-A1- 2015 024 811

## Beschreibung

Die Erfindung betrifft ein Gehäuseteil für eine elektronische Vorrichtung, bestehend aus kohlefaserverstärktem Kunststoff, wobei das Gehäuseteil mindestens eine Vorrichtung zur galvanischen Verbindung mit der im Gehäuse angeordneten Elektronik aufweist.

Elektronische Vorrichtungen, also Geräte, die eine Elektronik aufweisen und deren Elektronik eingehaust ist, benötigen in der Regel ein Gehäuseteil, welches die Elektronik selbst vor äußeren Umwelteinflüssen schützt, aber auch, welches die Umgebung vor der Elektrik der Elektronik schützt.

Elektronische Geräte mit einem elektronischen Schwingkreis benötigen ein Gehäuse, das selbst ein elektrisches Massepotential aufweist, um zu verhindern, dass das Gehäuse eine kapazitive Wirkung entfaltet und damit selbst einen unerwünschten Teil eines ungewollten Schwingkreises bildet, der zusammen mit der Elektronik ein elektronisches Rauschen in der erzeugten Schwingung erzeugt.

Das zuvor erwähnte Problem des Rauschens entsteht insbesondere bei Hochfrequenzanwendungen, wie zum Beispiel Radioempfängem, Funkgeräten und Mobiltelefonen und auch bei mobilen Datenerfassungsgeräten, die über ein Nah- bis Mittelfeldprotokoll erfasste Daten an ein entferntes Datenerfassungsgerät senden. Solche mobilen Datenerfassungsgeräte können Sensoren unterschiedlichster Art sein, wie sie im "Internet-of-Things" genannten Bereich bekannt sind. Bekannte Mobiltelefone weisen entweder ein elektrisch nichtleitendes Kunststoffgehäuse auf, so dass sich die Schwingkreis- und Rauschproblematik nicht einstellen kann, oder aber sie weisen ein metallisches Gehäuse auf, das durch eine elektrische Verbindung mit dem elektrischen Masseleiter, der in dem Gehäuse befindlichen Elektronik, auf die elektrische Masse gezogen wird.

In der als US 2015/0024811 A1 veröffentlichten Patentanmeldung wird ein Faserverstärktes Kunststoffgehäuse für ein Mobiltelefon offenbart. In solchen elektrisch nichtleitenden Kunststoffgehäusen tritt die Rauschproblematik nicht in den Vorderund.

Metallische Gehäuse für Mobiltelefone haben zwar den Vorteil der extremen Robustheit, aber weisen den Nachteil des hohen Gewichtes durch die spezifische Dichte des Materials auf. Bei der Gewichtsoptimierung für ein Mobiltelefon kommt es auf jedes eingesparte Gramm an, so dass Mobiltelefone in Innentaschen getragen werden können, wobei schon geringe Gewichtsunterschiede eine erhebliche Auswirkung auf den Tragekomfort haben. Neben der Robustheit können metallische Gehäuse für Mobiltelefone auch Teile der Antennenfunktion übernehmen, was bei nichtleitenden Kunststoffgehäusen nicht möglich ist.

Um Gewicht einzusparen, ist es bekannt, ein Gehäuse für ein Mobiltelefon aus kohlefaserverstärktem Kunststoff herzustellen. Kohlefaserverstärkter Kunststoff wird auch als carbonfaserverstärkter Kunststoff bezeichnet. Kohlefaserverstärkter Kunststoff kann als Verbundwerkstoff vorliegen, in dem die Kohlefasern ein Gewebe bilden, das zuvor mit nicht abgebundenem Kunststoff getränkt worden ist. Solche getränkten Gewebe werden als "Prepregs" bezeichnet. Für die Herstellung eines Artikels aus kohlefaserverstärktem Kunststoff werden Prepregs in eine Form gelegt und unter Wärmeeinwirkung bindet der die Kohlefasern umgebende Kunststoff ab. Alternativ zu Prepregs werden auch kohlefaserverstärkte Kunststoffe als Gussteile hergestellt. In gegossenen kohlefaserverstärkten Kunststoffen liegen die Kohlefasern als kurze, geschnittene Fasern im Kunststoff vor, wobei die geschnittenen Fasern statistisch im Kunststoff verteilt sind. Sowohl kohlefaserverstärkte Prepreg-Formteile als auch kohlefaserverstärkte Gussteile können Teile eines Verbundwerkstoffes sein. Schließlich ist es auch möglich, kohlefaserverstärkte Prepregs- und kohlefaserverstärkten Kunststoff als Guss miteinander zu verbinden, so dass sich ein Verbundwerkstoff bildet. Schließlich kann auch kohlefaserverstärkter Kunststoff mit thermoplastischem Kunststoff, der nicht unbedingt Kohlefasern enthalten muss, durch Umspritzen zu einem Verbundwerkstoff verbunden werden. Die Verwendung von kohlefaserverstärktem Kunststoff und/oder Verbundwerkstoffen daraus für ein Mobiltelefongehäuse hat den Vorteil, dass gegenüber einem metallischen Gehäuse relativ viel Gewicht eingespart werden kann, wobei der kohlefaserverstärkte Kunststoff in seinen Kohlefasern mit recht geringem elektrischem Widerstand elektrisch leitfähig ist. Die Kohlefasern von kohlefaserverstärktem Kunststoff können einen erwünschten Faraday'schen Käfig bilden und optional an der Antennenfunktion des Mobiltelefons teilnehmen. Weil die Kohlefasern von kohlefaserverstärktem Kunststoff elektrisch leitfähig sind, können die Kohlefasern ebenso wie ein metallisches Gehäuse einen unerwünschten Teil eines ungewollten Schwingkreises bilden. In der Folge kann sich bei der Verwendung eines Gehäuses aus kohlefaserverstärktem Kunststoff für ein Mobiltelefon ein elektronisches Rauschproblem einstellen, wobei das Gehäuse nicht ohne weiteres auf eine elektrische Masse gezogen werden kann. Die einzelnen Kohlefasern sind im sie umgebenden Kunststoff von einer nichtleitenden, organischen Kunststoffschicht umgeben. Somit haben die einzelnen Fasern ein ungeerdetes Potential. Fachsprachlich bezeichnet man diesen Zustand so, dass die Fasern "hoch" liegen, englisch ("high impedance state") womit gemeint ist, dass die einzelnen Fasern kein geerdetes Potential aufweisen oder zumindest kein Massepotential aufweisen, wobei die elektrische Masse eines elektronischen Gerätes nicht unbedingt das elektrische Potential der Erde haben muss.

Aufgabe der Erfindung ist es, ein Gehäuse für eine elektronische Vorrichtung zur Verfügung zu stellen, welches aus kohlefaserverstärktem Kunststoff besteht und die zuvor beschriebene Rauschproblematik nicht aufweist.

Die der Erfindung zu Grunde liegende Aufgabe wird gelöst durch ein Gehäuse mit den Merkmalen nach Anspruch 1. Weitere vorteilhafte Ausgestaltungen sind in den Unteransprüchen zu Anspruch 1 angegeben.

Nach dem Gedanken der Erfindung ist also vorgesehen, dass für solche Gehäuse, die mindestens eine Vorrichtung zur galvanischen Verbindung mit der im Gehäuse angeordneten Elektronik aufweisen, beispielsweise zum Befestigen eines Rahmens zur Aufnahme einer Elektronik, dieses benachbart zu-mindestens einer Vorrichtung zur galvanischen Verbindung mit der im Gehäuse angeordneten Elektronik mindestens eine Nut im Gehäuseteil aufweist, welche mit einer abgebundenen, leitfähigen Masse ausgefüllt ist, wobei die leitfähige Masse mit der Vorrichtung zur galvanischen Verbindung selbst mit der im Gehäuse angeordneten Elektronik galvanisch verbunden ist. Nach dem Gedanken der Erfindung ist es vorgesehen, dem Gehäuse aus kohlefaserverstärktem Kunststoff dadurch ein Massepotential zu verleihen, in dem die Kohlefasern eines kohlefaserverstärkten Kunststoffes, aus dem das Gehäuse besteht, galvanisch mit der Vorrichtung zur galvanischen Verbindung mit der im Gehäuse angeordneten Elektronik verbunden werden. Die Nut in dem Gehäuse ist in vorteilhafter Weise durch Fräsen eingebracht und zwar nachdem der Kunststoff abgebunden ist oder sich gefestigt hat. Durch das Fräsen werden die einzelnen Kohlefasern freigelegt. Manche Kohlefasern werden durchtrennt, so dass der Querschnitt der einzelnen Kohlefasern freiliegt. Andere Kohlefasern werden seitlich angefräst, so dass eine Seite einer Kohlefaser freiliegt. Noch andere Kohlefasern werden schräg geschnitten, so dass eine schräge Schnittfläche der Kohlefaser freiliegt. Da Kohlefasern einen spezifischen, elektrischen Widerstand haben, der mit dem spezifischen, elektrischen Widerstand vieler Metalle vergleichbar ist, ist das Fräsen in die Oberfläche des Gehäuses vergleichbar mit dem Freilegen einzelner Seelen eines Kupferkabels. Die elektrisch leitfähige Masse in der Nut kann eine elektrisch leitfähige Tinte sein. Hierzu bieten sich Silbertinten an, die flüssig oder pastos eine Suspension von Silberpartikeln aufweisen. Beim Abbinden des Tintenträgers berühren sich die Silberpartiklel, wodurch die Tinte im abgebundenen Zustand einen vergleichsweise geringen elektrischen Widerstand auch über längere Distanzen aufweist. Leitfähige Tinten haben den Vorteil, dass sie kalt, also bei Raumtemperatur, ausgebracht werden können. Je nach Beschaffenheit des Kunststoffes im kohlefaserverstärkten Kunststoff kann auch auf ein Weichlot aus Silberbasis oder auf Zinnbasis als leitfähige Masse zurückgegriffen werden. Ist der Kunststoff des kohlefaserverstärkten Kunststoffes ein Epoxidharz, so ist es möglich, die Nut mit Weichloten auszufüllen, die eine Schmelztemperatur von unter 300°C, bevorzugt von unter 200°C, haben und in galvanischen Kontakt mit den Kohlefasern einerseits und mit der Vorrichtung zur galvanischen Verbindung mit der im Gehäuse angeordneten Elektronik andererseits in Verbindung zu bringen. Als Kunststoffe kommen in Betracht: kohlefaserverstärkter Kunststoff, wobei der Kunststoff ein thermoplastisches Polymer sein kann oder ein duroplastisches Polymer. Die Erfindung kommt auch in Betracht für kohlefaserverstärkte Kunststoffe, die einen elektrisch leitfähigen Kunststoff aufweisen. Trotz der elektrischen Leitfähigkeit des Kunststoffes kann es nämlich sein, dass die Kohlefasern darin durch eine Trennschicht auf der Oberfläche der Kohlefasern vom elektrisch leitfähigen Kunststoff elektrisch isoliert sind. Unter "kohlefaserverstärktem Kunststoff" wird im Rahmen dieser Anmeldung jegliche Kunststoffart und Verbundstoffart verstanden, die Kohlefasergelege, Kohlefasergewebe, Kohlefasergewirke und/oder Kohlkefasergestricke zur mechanischen Verstärkung des Kunststoffes oder des Verbundwerkstoffes aufweisen. Verbundwerkstoffe können beispielsweise Schichten aufweisen, in denen eine einzelne oder mehrere Schichten aus einem abgebundenen kohlefaserverstärkten Epoxid-Harz bestehen und andere einzelne oder mehrere Schichten aus einem durch Umspritzen mit dem kohlefaserverstärkten Epoxid-Harz verbundenen Thermoplast bestehen. Die elektrische Leitfähigkeit des Kunststoffes kann durch Beimengung von elektrisch leitfähigen Füllmaterialien erhalten worden sein oder kumulativ oder alternativ aus elektrisch leitfähigen Kunststoffpolymeren bestehen, wie beispielsweise dotiertes Polypyrrol oder andere dotierte oder nicht dotierte polyannelierte Kunststoffe, wie Poly-3,4-ethylendioxythiophen (PEDOT), Polyanilin, Polyparaphenylen oder Polythiophen oder Mischungen daraus. Kunststoffgemische aus Kunststoffen verschiedener Art zur Hervorhebung von besonderen Eigenschaften werden industrietypisch als 'Compounds' bezeichnet. Compounds umfassen Hochleistungskunststoffe, Gemische aus Kunststoffen und Kunststoffe, die aus mehr als einer Lage bestehen, wobei die Lagen unterschiedliche Kunststoffe aufweisen.

Als Gehäuseteil für ein Mobiltelefon als elektronische Vorrichtung kommt insbesondere in Betracht, dass der Aufbau eine deckelartige Struktur aufweist, in welcher eine ebene Rückfront einen Seitenrand aufweist, wobei in der Innenecke zwischen der ebenen Rückfront und dem Seitenrand eine stufenartige Erhebung vorhanden ist, innerhalb derer die Vorrichtung zur galvanischen Verbindung mit der im Gehäuse angeordneten Elektronik aufgenommen ist. Die Vorrichtung zur galvanischen Verbindung mit der im Gehäuse angeordneten Elektronik hat also ihren Sitz in der stufenartigen Erhebung. Dabei kann die stufenartige Erhebung aus einem Gusskunststoff bestehen, beispielsweise aus einem thermoplastischen Kunststoff oder auch aus einem kohlefaserverstärktem Gusskunststoff. Dieser Teil des Gehäuses kann durch ein Umspritzverfahren hergestellt sein (engl. "overmolding"). Beim Umspritzen des Gehäuses wird zunächst ein Gehäuserohling aus Prepregs in eine Form gelegt und in der Form erwärmt. Dabei härtet der Kunststoff in der Form aus. Danach wird der Gehäuserohling in derselben Form oder in einer weiteren Form mit dem Umspritzverfahren mit einer Kunststoffschicht aus einem weiteren Kunststoff überschichtet, indem der weitere Kunststoff auf den Gehäuserohling aufgespritzt wird. In der Spritzform befinden sich bereits die Vorrichtung zur galvanischen Verbindung mit der im Gehäuse angeordneten Elektronik, die durch den Guss- oder Spritzkunststoff mit dem Gehäuserohling verbunden werden. Dazu kann die Vorrichtung zur galvanischen Verbindung mit der im Gehäuse angeordneten Elektronik ein metallischer Gewindeeinsatz sein oder eine elektrisch leitfähige Auflagefläche, welche später über einen elektrisch leitfähigen Schwamm (engl. "pouch") mit der aufliegenden Platine elektrisch verbunden ist.

Das Einbringen einer Nut in das Gehäuse kann je nach Gehäuseform zu einer unerwünschten bevorzugten Bruchstelle führen, weil die Nut eine ungewollte Materialschwächung darstellt. Es ist dabei abhängig von der Geometrie des Gehäuses, ob und wie sich mechanische Spannungen im Gehäuse so ausbreiten, dass die Nut eine bevorzugte Bruchkante bildet. Um unabhängig von der Gehäusegeometrie das Ausbilden einer bevorzugten Bruchkante zu vermeiden, kann vorgesehen sein, dass die Nut mäanderförmig ausgestaltet ist. Dabei ist die Mäanderstruktur entlang ihrer Erstreckungslinie etwa parallel zu einem Gehäuserand ausgerichtet. Die näherungsweise Parallelität der Erstreckungslinie der mäanderförmigen Nut bewirkt, dass der Gehäuserand die mechanischen Kräfte im Bereich der Nut soweit aufnimmt, dass es nicht zu einem bevorzugten Bruch in der Nut kommt.

Ist das Gehäuse beispielsweise aus mehreren Prepreg-Lagen oder Lagen aus verschiedenen Kunststoffen aufgebaut, so ist es vorteilhaft, wenn vorgesehen ist, dass die Nut in der Tiefe mindestens eine Lage kohlefaserverstärkten Kunststoffs vollkommen durchstößt. Dadurch ist sichergestellt, dass zumindest eine innerste Schale des Gehäuses ein elektrisches Massepotential aufweist. Um die galvanische Verbindung der elektrisch leitfähigen Masse mit dem metallischen Gewindeeinsatz zu verbessern, so dass ein möglichst geringer elektrischer Übergangswiderstand entsteht, kann es vorgesehen sein, dass der metallische Gewindeeinsatz angefräst ist, wobei die leitfähige Masse galvanisch mit der angefrästen Stelle verbunden ist. Durch das Anfräsen werden mögliche Oberflächenveredelungen, Lackierungen und/oder metallisch nicht leitende Oxidschichten durchbrochen und die Benetzung des metallischen Gewindeeinsatzes durch die elektrisch leitfähige Masse, sei es eine elektrisch leitfähige Tinte oder ein Weichlot, wird unter Ausbildung eines möglichst geringen elektrischen Übergangswiderstandes intensiviert.

Die Erfindung wird anhand der folgenden Figuren näher erläutert. Es zeigt:
- Fig. 1: eine Abbildung eines hinteren Gehäuseteils eines Mobiltelefons als elektronische Vorrichtung mit Detail A,
- Fig. 2: Detail A aus Figur 1 mit eingezeichneter Schnittebene B,
- Fig. 3.1: eine Ansicht auf die Schnittebene B in Figur 2 aus Detail A,
- Fig. 3.2: ein Gewindeeinsatz, wie er in dem Gehäuse eingesetzt ist,
- Fig. 4.1: eine Ansicht auf die Schnittebene B in Figur 2 aus Detail A mit erfindungsgemäßer, ausgefüllter Nut,
- Fig. 4.2: ein angefräster Gewindeeinsatz,
- Fig. 5.1: eine Ansicht auf die Innenseite eines Gehäuses mit mäanderförmiger Nut,
- Fig. 5.2: eine Ansicht auf die Innenseite eines erfindungsgemäßen Gehäuses mit mäanderförmiger Nut, die mit einer elektrisch leitfähigen Masse ausgefüllt ist,
- Fig. 6.1: eine alternative Ausführungsform des Gehäuses mit einem elektrisch leitfähigen Schwamm,
- Fig. 6.2: der elektrisch leitfähige Schwamm aus Figur 6.1,
- Fig. 7: eine alternative Ausführungsform des erfindungsgemäßen Gehäuseteils,
- Fig. 8: eine weitere, alternative Ausführungsform des erfindungsgemäßen Gehäuseteils.

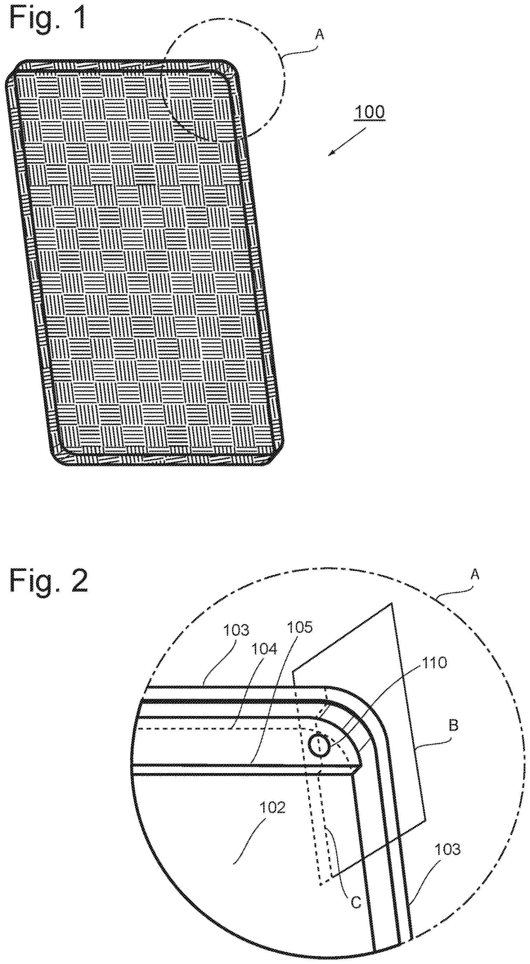

In **Figur 1** ist ein Anblick auf die Innenseite auf einen rückseitigen Gehäusedeckel 100 eines Mobiltelefons als elektronische Vorrichtung dargestellt. In Figur 1 ist ein Kreis um ein Detail A gezeigt, das in der folgenden Figur 2 vergrößert und mit weiteren Details dargestellt ist.

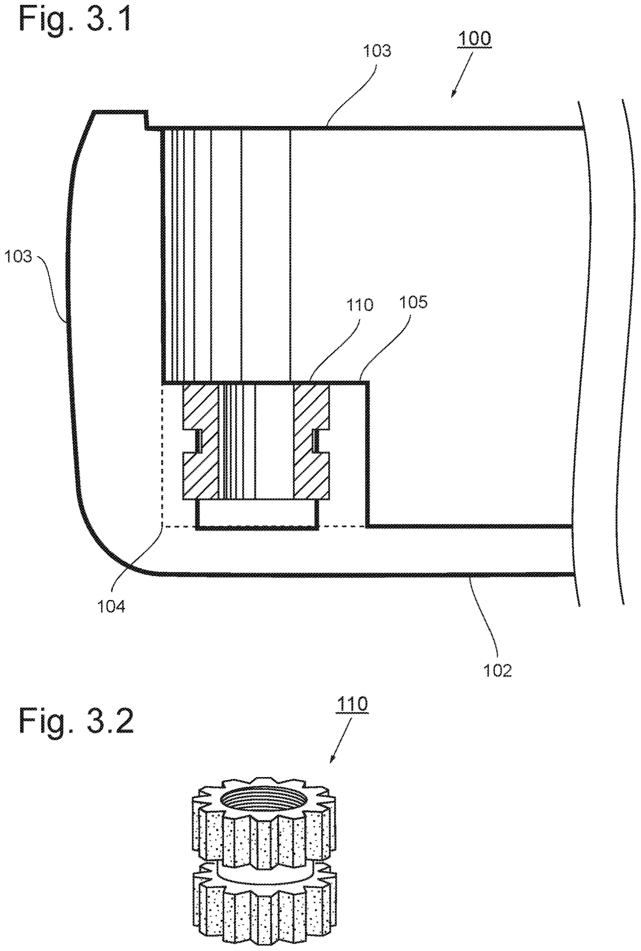

In **Figur 2** ist das Detail A aus Figur 1 in einer vergrößerten Ansicht mit weiteren Details gezeigt. In der rechten oberen Ecke des Gehäuses 100 ist eine Schnittebene B gezeigt, die mit dem Gehäuse 100 eine Schnittlinie C bildet. Eine Ansicht auf die Schnittebene B ist in Figur 3.1 dargestellt. In Figur 2 ist gezeigt, dass in der oberen Innenecke 104 zwischen einer ebenen Rückfront 102 und einem Seitenrand 103 eine stufenförmige Erhebung 105 angeordnet ist. In diese stufenförmige Erhebung 105 ist ein metallischer Gewindeeinsatz 110 durch Umspritzen eingeformt, der in Figur 3.1 näher erläutert wird.

In **Figur 3****.****1** ist eine Ansicht auf die Schnittebene B aus Figur 2 in einer Ansicht von der in Figur 2 linken Seite gezeigt. In die stufenförmige Erhebung 105, die in einer Innenecke 104 zwischen der ebenen Rückfront 102 und einem Seitenrand 103 ist ein metallischer Gewindeeinsatz 110, dargestellt in Figur 3.2, durch Umspritzen eingeformt. Dieser metallische Gewindeeinsatz 110 dient zum Befestigen eines Montagerahmens einer Elektronik oder zur Befestigung einer Platine. Dabei kann der Rahmen oder der Befestigungspunkt der Platine mit einem metallischen Leiter verbunden sein, der ein elektrisches Massepotential der Elektronik aufweist. Um das Gehäuse 100 großflächig auf Masse zu ziehen im elektrotechnischen Sinne, ist es nun vorgesehen, den metallischen Gewindeeinsatz 110, der hier in diesem Ausführungsbeispiel in einem Teil des Verbundgehäuses sitzt, der durch Umspritzen mit elektrisch wenig leitfähigem Kunststoff erstellt worden ist, mit den Kohlefasern 101 des Gehäuses galvanisch zu verbinden.

In **Figur 3****.****2** ist ein gattungsgemäßer Gewindeeinsatz 110 dargestellt, der in dem Gehäuse 100 zur Befestigung einer Platine oder eines Befestigungsrahmens mit einer Schraube dient.

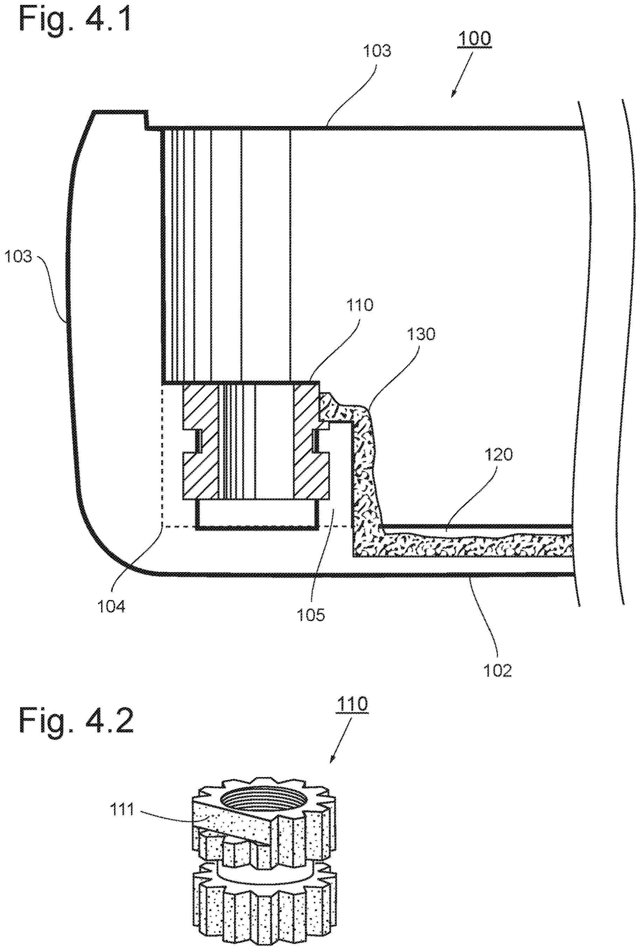

In **Figur 4****.****1** ist die Ansicht aus Figur 3.1 um die erfindungsgemäße und elektrisch leitfähige Masse 130 in einer zum Gewindeeinsatz 110 benachbarten Nut 120 ergänzt. Die Nut 120 ist rückseitig in die Rückfront 102 eingebracht, wobei durch das Einbringen der Nut 120 Kohlefasern 101 offengelegt werden. Die elektrisch leitfähige Masse 130, beispielsweise elektrisch leitfähige Tinte oder Weichlot füllt die Nut 120 und verbindet die Kohlefasern 101 mit dem metallischen Gewindeeinsatz 110 in galvanischer Weise, so dass elektrischer Strom vom Gewindeeinsatz 110 über die elektrisch leitfähige Masse 130 in die Kohlefasern 101 strömen kann, die in der Nut 120 freigelegt sind und umgekehrt. Durch die elektrisch leitfähige Verbindung zeigt das Gehäuse 100 ein elektrisches Potential des Gewindeeinsatzes 110. Der Gewindeeinsatz 110 kann mit einem hier nicht gezeigten Befestigungsrahmen verbunden sein, der selbst elektrisch auf Masse liegt oder aber der Gewindeeinsatz 110 kann über eine korrespondierende Schraube mit einem elektrischen Massekontakt auf einer Elektronik-Platine verbunden sein. Dadurch zeigt dann auch das Gehäuse ein elektrisches Massepotential. Ist nun im Gehäuse 100 eine Hochfrequenz-Antenne verbaut, wie es für Mobiltelefone gebräuchlich ist oder für mobile Datenerfassungsgeräte, die über ein lokales Funknetz (bspw. WLAN, LTE, GSM) oder über ein Nahfeldprotokoll (bspw. BlueTooth) Daten an eine entfernte Datensammelstation weiterleiten, so wird durch das elektrische Massepotential des Gehäuses 100 vermieden, dass das Gehäuse Ursache für ein elektronisches Rauschen ist.

Um die elektrische Verbindung des Gewindeeinsatzes 110 mit der elektrisch leitfähigen Masse zu verbessern, also mit einem möglichst geringen elektrischen Übergangswiderstand auszustatten, kann es vorteilhaft sein, wenn der Gewindeeinsatz 110 äußerlich angefräst ist, wie es in Figur 4.2 gezeigt ist.

In **Figur 4****.****2** ist der Gewindeeinsatz 110 mit einer angefrästen Stelle 111 dargestellt. Ist die angefräste Stelle 111 frisch erzeugt, so liegt blankes Metall frei und ist frei von Oxiden, Lacken und/oder Oberflächenveredelungen. Das blanke Metall lässt sich gut mit der elektrisch leitfähigen Masse 130 benetzen.

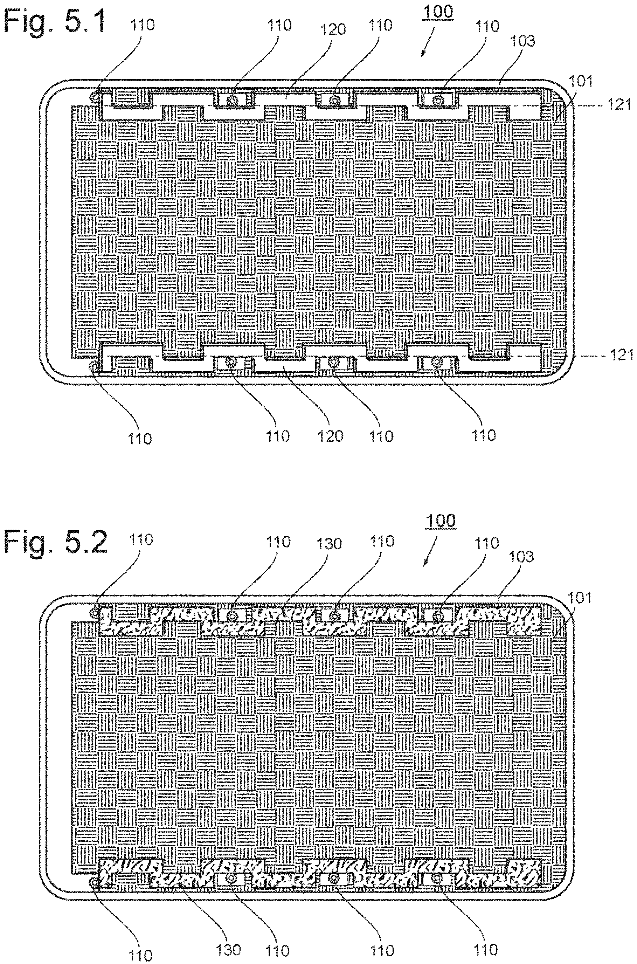

In **Figur 5****.****1** ist eine detaillierte Innenansicht auf das Gehäuse 100 gezeigt, das eine Nut 120 aufweist, die benachbart ist zu mehreren Gewindeeinsätzen 110. Um zu vermeiden, dass die Nut 120 als bevorzugte Bruchstelle auftritt, ist die Nut 120 mäandriert ausgeführt. Dabei verläuft die Erstreckungslinie 121 der Nut 120 parallel zur Seitenkante 103. Durch diese Anordnung kann die Seitenkante 103 mechanische Kräfte aufnehmen, die im Bereich der Nut 120 bei mechanischer Belastung des Gehäuses 100 entstehen. Durch die Mäandrierung verlaufen sich die mechanischen Stresslinien so sehr, dass ein Bruch nicht bevorzugt in der Mäanderlinie der Nut 120 auftritt.

In **Figur 5****.****2** ist schließlich eine detaillierte Innenansicht auf das Gehäuse 100 gezeigt, wobei die Nut 120 mit einer elektrisch leitfähigen Masse 130 ausgefüllt ist. In der Nut 120 liegen die Kohlefasern 101 frei, so dass die elektrisch leitfähige Masse die Kohlefasern 101 galvanisch mit den Gewindeeinsätzen verbunden. Ist nun je ein Gewindeeinsatz 110 mit einem elektrischen Massepotential verbunden, so liegen auch die Kohlefasern 101 auf dem Massepotential. Die elektrisch leitfähige Masse 130 in der Nut 120 verbindet auch die verschiedenen Gewindeeinsätze 110 untereinander, so dass sämtliche Gewindeeinsätze 110 das gleiche elektrische Potential aufweisen. Die elektrisch leitfähige Masse 130 in der Nut 120 übernimmt über den Umweg über die Gewindeeinsätze 110, die selbst mit einem elektrischen Kontakt auf einer Platine über eine korrespondierende Schraube verbunden sein können, die Funktion einer Leiterbahn, die bevorzugt zum Erden beziehungsweise zum Potentialausgleich unterschiedlicher Einzelteile der elektronischen Vorrichtung verwendet wird. Das hier als Beispiel erwähnte Mobiltelefon steht dabei stellvertretend für andere elektronische Vorrichtungen, wie Funkgeräte oder andere Geräte mit einer Funkfernverbindung oder Funkempfänger.

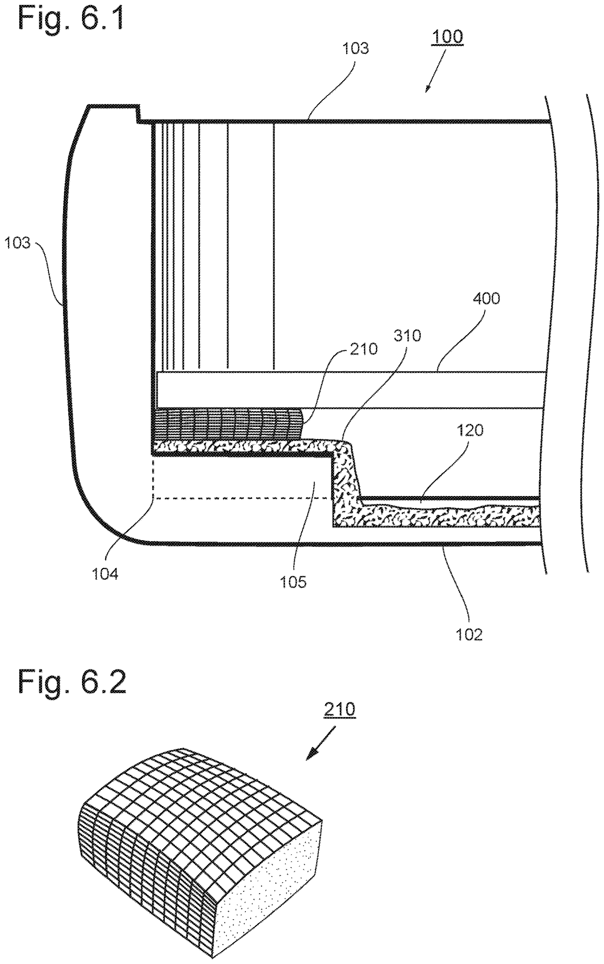

In **Figur 6****.****1** ist eine alternative Ausführungsform des Gehäuses mit einem elektrisch leitfähigem Schwamm 210 dargestellt. Die Ansicht ähnelt der Ansicht in Figur 4.1, wobei jedoch der metallische Gewindeeinsatz 110 durch eine elektrisch leitfähige Auflagefläche ersetzt ist, auf der ein elektrisch leitfähiger Schwamm 210 aufliegt. Die Nut 120 ist rückseitig in die Rückfront 102 eingebracht, wobei durch das Einbringen der Nut 120 Kohlefasern 101 offengelegt werden. Die elektrisch leitfähige Masse 130, beispielsweise elektrisch leitfähige Tinte oder Weichlot, füllt die Nut und verbindet die Kohlefasern 101 mit dem aufliegenden elektrisch leitfähigen Schwamm 210 in galvanischer Weise, so dass elektrischer Strom durch den elektrisch leitfähigen Schwamm 210 und über die elektrisch leitfähige Masse 130 in die Kohlefasern 101 strömen kann, die in der Nut 120 freigelegt sind und umgekehrt. Durch die elektrisch leitfähige Verbindung zeigt das Gehäuse 100 ein elektrisches Potential des elektrisch leitfähigen Schwamms 210. Der elektrisch leitfähige Schwamm 210 kann mit einem hier nicht gezeigten Befestigungsrahmen verbunden sein, der selbst elektrisch auf Masse liegt oder aber der elektrisch leitfähige Schwamm 210 kann als Auflagepunkt für eine Elektronik-Platine 400 dienen. Dadurch zeigt dann auch das Gehäuse ein elektrisches Massepotential. Ist nun im Gehäuse 100 eine Hochfrequenz-Antenne verbaut, wie es für Mobiltelefone gebräuchlich ist oder für mobile Datenerfassungsgeräte, die über ein lokales Funknetz (WLAN) oder über ein Nahfeldprotokoll (BlueTooth) Daten an eine entfernte Datensammelstation weiterleiten, so wird durch das elektrische Massepotential des Gehäuses 100 vermieden, dass das Gehäuse Ursache für ein elektronisches Rauschen ist.

In **Figur 6****.****2** ist der elektrisch leitfähige Schwamm 210 gezeigt. Dieser Schwamm 210 ist eingefasst in ein Netz aus elektrisch leitfähigen Fäden und kann mit einer leitfähigen Paste getränkt sein.

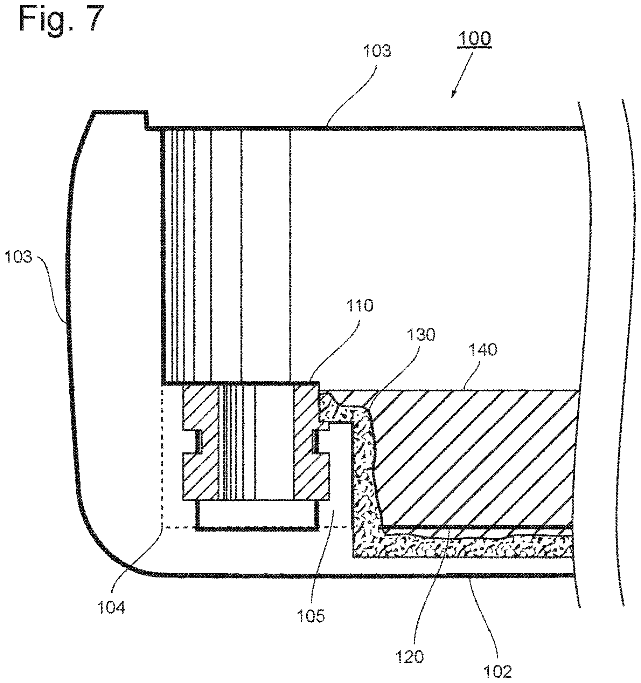

In **Figur 7** ist eine alternative Ausführungsform des erfindungsgemäßen Gehäuseteils 100 gezeigt. Diese Ausführungsform unterscheidet sich von der Variante in Figur 4.1 durch eine Überlagerung der elektrisch leitfähigen Masse 130 durch einen Kunststoff 140, der vorzugsweise durch Umspritzen mit dem Gehäuseteil 100 verbunden worden ist. Der Kunststoff 140 stabilisiert den gegebenenfalls durch Einbringen der Nut 120 erlittenen Stabilitätsverlust des Gehäuseteils 100 und stellt eine elektrische Isolierung der elektrisch leitfähigen Masse 130 dar.

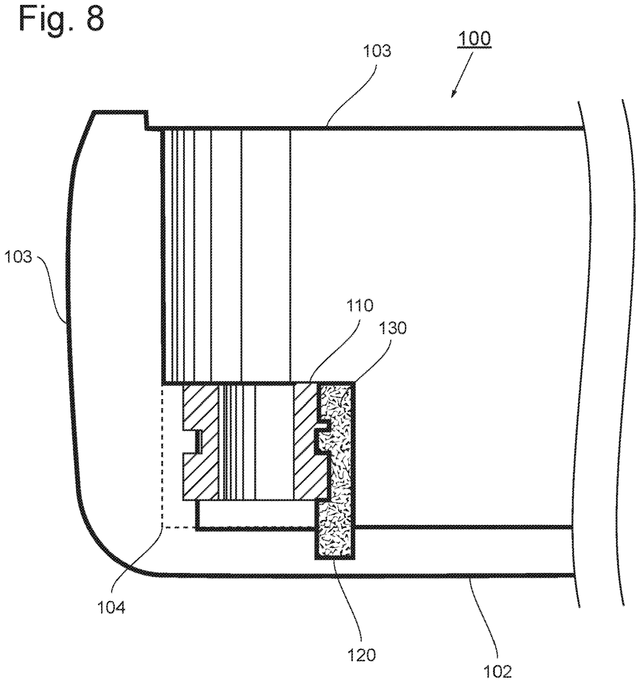

In **Figur 8** ist noch eine weitere alternative Ausführungsform des erfindungsgemäßen Gehäuseteils 100 gezeigt. In diesem Ausführungsbeispiel bildet die leitfähige Masse 130, die hier aus einem elektrisch leitfähigen Kunststoff besteht, einen Teil der stufenförmigen Erhebung 105. Dabei ragt der elektrisch leitfähige Kunststoff der elektrisch leitfähigen Masse 130 in die Rückfront 102 hinein, indem es in einer Nut 120 steht, so dass der elektrisch leitfähige Kunststoff mit den einzelnen Fasern des kohlefaserverstärkten Kunststoffs der Rückfront 102 in elektrischem Kontakt steht.

### BEZUGSZEICHENLISTE

| | | | |
|---|---|---|---|
| 100 | Gehäuseteil | 130 | Masse |
| 101 | Kohlefaser | 140 | Kunststoff |
| 102 | Rückfront | 21 0 | leitfähiger Schwamm |
| 103 | Seitenrand | 310 | Auflagefläche |
| 104 | Innenecke | 400 | Platine |
| 105 | Erhebung | | |
| 110 | Gewindeeinsatz | A | Detail |
| 111 | angefräste Stelle | B | Schnittebene |
| 120 | Nut | C | Schnittlinie |
| 121 | Erstreckungslinie | | |

## Patentansprüche

1. Gehäuseteil (100) für eine elektronische Vorrichtung, bestehend aus kohlefaserverstärktem Kunststoff, wobei das Gehäuseteil (100) mindestens eine Vorrichtung zur galvanischen Verbindung mit der im Gehäuse angeordneten Elektronik aufweist,
wobei benachbart zur mindestens einen Vorrichtung zur galvanischen Verbindung mit der im Gehäuse angeordneten Elektronik mindestens eine Nut (120) im Gehäuseteil (100) vorhanden ist,
**dadurch gekennzeichnet, dass**
die Nut (120) mit einer leitfähigen Masse (130) ausgefüllt ist, wobei die leitfähige Masse (130) mit der Vorrichtung zur galvanischen Verbindung selbst mit der im Gehäuse angeordneten Elektronik galvanisch verbunden ist,
indem die Nut (120) eine Einfräsung ist, welche Kohlefasern (101) des kohlefaserverstärkten Kunststoffs freilegt, so dass die leitfähige Masse (130) galvanisch mit den freigelegten Kohlefasern (101) verbunden ist.

2. Gehäuseteil nach Anspruch 1,
**dadurch gekennzeichnet, dass**
die Vorrichtung zur galvanischen Verbindung mit der im Gehäuse angeordneten Elektronik ausgesucht ist aus der Gruppe bestehend aus: ein metallischer Gewindeeinsatz (110), leitfähiger Schwamm (210), elektrisch leitfähige Auflagefläche (310), elektrisch leitfähiger Kunststoff.

3. Gehäuseteil nach einem der Ansprüche 1 oder 2,
**dadurch gekennzeichnet, dass**
der Aufbau eine deckelartige Struktur aufweist, in welcher ebene Rückfront (102) einen Seitenrand (103) aufweist, wobei in der Innenecke (104) zwischen der ebenen Rückfront (102) und dem Seitenrand (103) eine stufenartige Erhebung (105) vorhanden ist, innerhalb derer die Vorrichtung zur galvanischen Verbindung mit der im Gehäuse angeordneten Elektronik aufgenommen ist.

4. Gehäuseteil nach Anspruch 3,
**dadurch gekennzeichnet, dass**
die ebene Rückfront (102) und der Seitenrand (103) aus abgebundenen Kohlefaser-Prepregs besteht und die stufenartige Erhebung (105) aus einem Thermoplast besteht, wobei die Kohlefaser-Prepregs und der Thermoplast als Verbundwerkstoff miteinander verbunden sind.

5. Gehäuseteil nach einem der Ansprüche 3 oder 4,
**dadurch gekennzeichnet, dass**
die Nut (120) mäanderförmig ausgebildet ist und sich mit ihrer Erstreckungslinie (121) etwa parallel zu dem Seitenrand (103) erstreckt.

6. Gehäuseteil nach einem der Ansprüche 4 oder 5,
**dadurch gekennzeichnet, dass**
die Nut (120) in der Tiefe mindestens eine Kohlefaser Prepreg-Lage vollkommen durchstößt.

7. Gehäuseteil nach einem der Ansprüche 2 bis 6,
**dadurch gekennzeichnet, dass**
der metallische Gewindeeinsatz (110) angefräst ist, wobei die leitfähige Masse (130) galvanisch mit der angefrästen Stelle (111) verbunden ist.

8. Gehäuseteil nach einem der Ansprüche 1 bis 7,
**dadurch gekennzeichnet, dass**
die leitfähige Masse (130) Silbertinte ist, ein Weichlot auf Silberbasis und/oder auf Zinnbasis ist, oder ein elektrisch leitfähiger Kunststoff ist.

9. Gehäuseteil nach einem der Ansprüche 1 bis 8,
**dadurch gekennzeichnet, dass**
die Kohlefasern des kohlefaserverstärkten Kunststoffes eine Länge aufweisen, die sich über die gesamte Länge des Gehäuseteils (100) erstreckt.

10. Gehäuseteil nach einem der Ansprüche 1 bis 9,
**dadurch gekennzeichnet, dass**
die elektrisch leitfähige Masse (130) durch Kunststoff (140) bedeckt ist, wobei der bedeckende Kunststoff (140) bevorzugt durch Umspritzen über der elektrisch leitfähigen Masse (130) in der Nut (120) angeordnet worden ist.

11. Gehäuseteil nach einem der Ansprüche 1 bis 10,
**dadurch gekennzeichnet, dass**
der kohlefaserverstärkte Kunststoff einen elektrisch leitfähigen Kunststoff aufweist, wobei der elektrisch leitfähige, kohlefaserverstärkte Kunststoff allein oder als Verbundwerkstoff aus mehr als einer Kunststoffschicht vorliegt.

12. Gehäuseteil nach einem der Ansprüche 1 bis 11,
**dadurch gekennzeichnet, dass**
dass der kohlefaserverstärkte Kunststoff Polypyrrol oder mindestens einen anderen dotierten oder nicht dotierten polyannelierten Kunststoff, wie Poly-3,4-ethylendioxythiophen, Polyanilin, Polyparaphenylen oder Polythiophen oder Mischungen als Compounds daraus aufweist.

13. Verwendung eines Gehäuseteils nach einem der Ansprüche 1 bis 12 für ein Mobiltelefon, für ein Funkgerät, für einen Tablett-Computer oder für ein mobiles Datenerfassungsgerät.

## Claims

1. Housing part (100) for an electronic device, comprising carbon-fiber reinforced plastic, wherein the housing part (100) has at least one device for galvanic connection to the electronics arranged in the housing,
wherein at least one groove (120) is present in the housing part (100) adjacent to the at least one device for galvanic connection to the electronics arranged in the housing,
***characterized in that***
the groove (120) is filled with a conductive compound (130), wherein the conductive compound (130) is itself galvanically connected to the device for galvanic connection to the electronics arranged in the housing,
by milling the groove (120) which exposes carbon fibers (101) of the carbon-fiber-reinforced plastic, so that the conductive compound (130) is galvanically connected to the exposed carbon fibers (101).

2. Housing part according to claim 1,
***characterized in that***
the device for galvanic connection to the electronics arranged in the housing is selected from the group consisting of: a metallic threaded insert (110), a conductive sponge (210), an electrically conductive contact surface (310), an electrically conductive plastic.

3. Housing part according to one of claims 1 or 2,
***characterized in that***
the construction has a cover-like structure in which a planar back face (102) has a side edge (103), wherein a step-like elevation (105) is present in the inner corner (104) between the planar back face (102) and the side edge (103) and within which step-like elevation the device for galvanic connection to the electronics arranged in the housing is arranged.

4. Housing part according to claim 3,
***characterized in that***
the planar back face (102) and the side edge (103) comprise hardened carbon-fiber prepregs and the step-like elevation (105) comprises a thermoplastic, wherein the carbon-fiber prepregs and the thermoplastic are connected to each other as a composite material.

5. Housing part according to claim 3 or 4,
***characterized in that***
the groove (120) is designed as meander shaped and its line of extension (121) extends approximately parallel to the side edge (103).

6. Housing part according to one of claims 4 or 5,
***characterized in that***
the depth of the groove (120) completely penetrates at least one carbon-fiber prepreg layer.

7. Housing part according to one of claims 2 to 6,
***characterized in that***
the metallic threaded insert (110) is milled, wherein the conductive compound (130) is galvanically connected to the milled point (111).

8. Housing part according to one of claims 1 to 7,
***characterized in that***
the conductive compound (130) is silver ink, a silver-based and/or tin-based soft solder, or an electrically conductive plastic.

9. Housing part according to one of claims 1 to 8,
***characterized in that***
the carbon fibers of the carbon-fiber-reinforced plastic have a length which extends across the entire length of the housing part (100).

10. Housing part according to one of claims 1 to 9,
***characterized in that***
the electrically conductive compound (130) is covered by plastic (140), wherein the covering plastic has preferably been arranged by overmolding over the electrically conductive compound (130) in the groove (120).

11. Housing part according to one of claims 1 to 10,
***characterized in that***
the carbon-fiber-reinforced plastic has an electrically conductive plastic, wherein the electrically-conductive, carbon-fiber-reinforced plastic is present alone or is present as a composite material made from more than one plastic layer.

12. Housing part according to one of claims 1 to 11,
***characterized in that***
the carbon-fiber-reinforced plastic has polypyrrole or at least one other doped or undoped polyannelated plastic, such as poly-3,4-ethylenedioxythiophene, polyaniline, poly(para-phenylene), or polythiophene or mixtures there of as compounds.

13. Use of a housing part according to one of claims 1 to 12 for a mobile telephone, for a radio device, for a tablet computer, or for a mobile data acquisition device.

## Revendications

1. Partie de boîtier (100) pour un appareil électronique en matière plastique renforcée par des fibres de carbone, la partie de boîtier (100) présentant au moins un dispositif de liaison galvanique avec l'électronique disposée dans le boîtier.
au moins une rainure (120) étant présente dans la partie de boîtier (100) à proximité d'au moins un dispositif de liaison galvanique avec l'électronique disposée dans le boîtier,
***caractérisée en ce que***
la rainure (120) est remplie d'une masse conductrice (130), la masse conductrice (130) étant reliée galvaniquement au dispositif de liaison galvanique lui-même avec l'électronique disposée dans le boîtier,
du fait que la rainure (120) est un fraisage, qui expose les fibres de carbone (101) du plastique renforcé par des fibres de carbone, de sorte que la masse conductrice (130) est connectée galvaniquement aux fibres de carbone exposées (101).

2. Partie de boîtier selon la revendication 1,
***caractérisée en ce que***
le dispositif de liaison galvanique avec l'électronique disposée dans le boîtier est choisi dans le groupe constitué par : un insert fileté métallique (110), une éponge conductrice (210), une surface de contact électroconductrice (310), une matière plastique électroconductrice.

3. Partie de boîtier selon l'une des revendications 1 ou 2,
***caractérisée en ce que***
la structure a une structure en forme de couvercle dans laquelle une face avant plane (102) a un bord latéral (103), dans le coin intérieur (104), entre la face avant plane (102) et le bord latéral (103), est présente une élévation en forme de gradin (105), dans laquelle est logé le dispositif de liaison galvanique avec l'électronique disposée dans le boîtier.

4. Partie de boîtier selon la revendication 3,
***caractérisée en ce que***
la face avant plane (102) et le bord latéral (103) sont constitués de préimprégnés de fibres de carbone liées et l'élévation en forme de gradin (105) est constituée d'un thermoplastique, les préimprégnés de fibres de carbone et le thermoplastique étant liés ensemble sous forme de matériau composite.

5. Partie de boîtier selon l'une des revendications 3 ou 4,
***caractérisée en ce que***
la rainure (120) est sinueuse et s'étend avec sa ligne d'extension (121) approximativement parallèle au bord latéral (103).

6. Partie de boîtier selon l'une des revendications 4 ou 5,
***caractérisée en ce que***
la rainure (120) traverse en profondeur au moins une couche de préimprégné de carbone.

7. Partie de boîtier selon l'une quelconque des revendications 2 à 6,
***caractérisée en ce que***
l'insert fileté métallique (110) est fraisé, la masse conductrice (130) étant reliée galvaniquement au point fraisé (111).

8. Partie de boîtier selon l'une quelconque des revendications 1 à 7,
***caractérisée en ce que***
la masse conductrice (130) est de l'encre argentée, une soudure à base d'argent et/ou d'étain, ou un plastique électroconducteur.

9. Partie de boîtier selon l'une quelconque des revendications 1 à 8,
***caractérisée en ce que***
les fibres de carbone du plastique renforcé par des fibres de carbone ont une longueur s'étendant sur toute la longueur de la partie de boîtier (100).

10. Partie de boîtier selon l'une quelconque des revendications 1 à 9,
***caractérisée en ce que***
la masse électroconductrice (130) est recouverte d'une matière plastique (140), la matière plastique de recouvrement (140) étant de préférence disposée par sur-injection sur la masse électroconductrice (130) dans la rainure (120).

11. Partie de boîtier selon l'une quelconque des revendications 1 à 10,
***caractérisée en ce que***
le plastique renforcé par des fibres de carbone comprend un plastique électroconducteur, le plastique électroconducteur renforcé par des fibres de carbone étant présent seul ou sous la forme d'un matériau composite constitué de plus d'une couche de plastique.

12. Partie de boîtier selon l'une quelconque des revendications 1 à 11,
***caractérisée en ce que***
la matière plastique renforcée par des fibres de carbone contient du polypyrrole ou au moins une autre matière plastique polyannelée dopée ou non dopée, telle que du poly-3,4 éthylène dioxythiophène, de la polyaniline, du polyparaphénylène ou du polythiophène ou des mélanges de ceux-ci sous forme de composés.

13. Utilisation d'une partie de boîtier selon l'une des revendications 1 à 12 pour un téléphone mobile, pour une radio, pour une tablette ou pour un appareil mobile de saisie de données.
